Europäisches Patentamt

European Patent Office

Office européen des brevets

(11) Publication number: **0 217 953**
**A1**

# EUROPEAN PATENT APPLICATION

published in accordance with Art. 158(3) EPC

(21) Application number: 85903699.8

(22) Date of filing: 19.07.85

Data of the international application taken as a basis:

(86) International application number: **PCT/JP 85/00410**

(87) International publication number: **WO 86/00997 (13.02.86 86/4)**

(51) Int. Cl.⁴: **G 01 R 23/16**

(30) Priority: 20.07.84 JP 150880/84

(43) Date of publication of application: 15.04.87 **Bulletin 87/16**

(84) Designated Contracting States: **DE GB**

(71) Applicant: **YOKOGAWA MEDICAL SYSTEMS, LTD, 1-3, Sakaecho 6-chome Tachikawa-shi, Tokyo 190 (JP)**

(72) Inventor: **TAKEUCHI, Yasuhito Yokogawa Medical Systems, Ltd., 1-3, Sakaecho 6-Chome Tachikawa-shi, Tokyo 190 (JP)**
Inventor: **SANO, Shinichi Yokogawa Medical Systems, Ltd., 1-3, Sakaecho 6-Chome Tachikawa-shi, Tokyo 190 (JP)**
Inventor: **JIBIKI, Takao Yokogawa Medical Systems, Ltd., 1-3, Sakaecho 6-Chome Tachikawa-shi, Tokyo 190 (JP)**
Inventor: **HIGASHIIZUMI, Takao Yokogawa Medical Systems,Ltd., 1-3, Sakaecho 6-chome Tachikawa-shi, Tokyo 190 (JP)**

(74) Representative: **Henkel, Feiler, Hänzel & Partner, Möhlstrasse 37, D-8000 München 80 (DE)**

(54) **DOPPLER SIGNAL ANALYZER.**

(57) A Doppler signal analyzer analyzes the frequency of Doppler signals relying upon the frequency resolving power and the time resolving power that are adapted to the frequency band of the signals to be analyzed. The signals to be analyzed are divided into a plurality of frequency bands through band-pass means ($10_1$, $10_2$, $10_3$). The signals of the thus divided frequencies that have passed through band-pass means are obtained by signal-obtaining means (11) over a small time slot for the signals of high frequencies and over a large time slot for the signals of low frequencies. The signals obtained by the signal-obtaining means are subjected to Fourier transformation through Fourier transformation means (14).

S P E C I F I C A T I O N

DOPPLER SIGNAL ANALYZING APPARATUS

[Technical field]

The present invention relates to a Doppler signal analyzing apparatus for use in an ultrasonic CW Doppler system or a pulse Doppler system, and more particularly to such a Doppler singal analyzing apparatus in which the frequency resolution and time resolution of analyzed results are optimiged according to the frequency band of a Doppler signal.

[Background art]

Conventional Doppler signal frequency analysis is carried out with both of a frequency slot width and a time slot width being fixed. Since the frequency and time slot widths determine frequency and time resolutions, respectively, of the frequency analysis, these frequency and time resolutions are also fixed in the conventional frequency analysis. The frequency and time slot widths are reciprocals of each other so that if one of these slot widths is reduced, then the other slot width is increased, and so are the frequency and time resolutions.

Doppler signal frequency analysis serves to analyze a Doppler signal obtained over a time period corresponding to the time slot width. Therefore, a delay is caused over the time corresponding to the time slot width before analyzed results are produced. For example,
if the frequency slot width is 50 Hz and the time slot
width is 20 msec. as with a typical example in a medical
ultrasonic Doppler system, then the delay time is 20 msec.
The time resolution is also 20 msec. since the time slot
width is the same as the time resolution. Where the
ultrasonic Doppler system is employed for heart diagnosis,
the results of frequency analysis of the Doppler signal are
displayed or recorded simultaneously with an M-mode
ultrasonic image and an electrocardiogram or a phonocardiogram for mutual comparison. Although the M-mode ultrasonic
image and the electrocardiogram or phonocardiogram are
produced without no substantial time delay and with a high
time resolution, the results of Doppler signal frequency
analysis are obtained with a time delay of 20 msec., for
example, and a coarse time resolution. Therefore, it is
not suitable for such analyzed results to be used for
comparison with the M-mode ultrasonic image and the
electrocardiogram.

In order to reduce the time delay and increase
the time resolution, the time slot width should be reduced.
However, when the time slot width is reduced, the frequency
slot width is to be increased, resulting in a lowered frequency
resolution. As a result, the accuracy of frequency
analysis becomes lower in a lower frequency band.

The fixed frequency and time slot widths cannot
therefore meet contradictory requirements for the frequency resolution and the time resolution or the time delay.

[Disclosure of the invention]

It is an object of the present invention to provide a Doppler signal analyzing apparatus capable of frquency analysis which matches the frequency band of a Doppler signal.

According to the present invention, a Dopper signal analyzing apparatus divides a signal to be analyzed into a plurality of frequency bands with bandpass means $(10_1, 10_2, 10_3)$, and signals in the frequency bands which have passed through the bandpas means are acquired by signal acquiring means (11) over time slots that are smaller for higher-frequency signals and larger for lower-frequency signals. The signals acquired by the signal acquiring means are subjected to a Fourier transform by Fourier transform means (14).

[Brief description of the drawings]

FIG. 1 is a block diagram of an embodiment of the present invention;

FIG. 2 is a timing chart of operation of the embodiment of FIG. 1; and

FIG. 3 is a diagram of a bit map in a spectrum image memory in the embodiment of FIG. 1.

[Best mode for carrying out the invention]

An embodiment of the present invention will hereinafter be described with reference to the drawings.

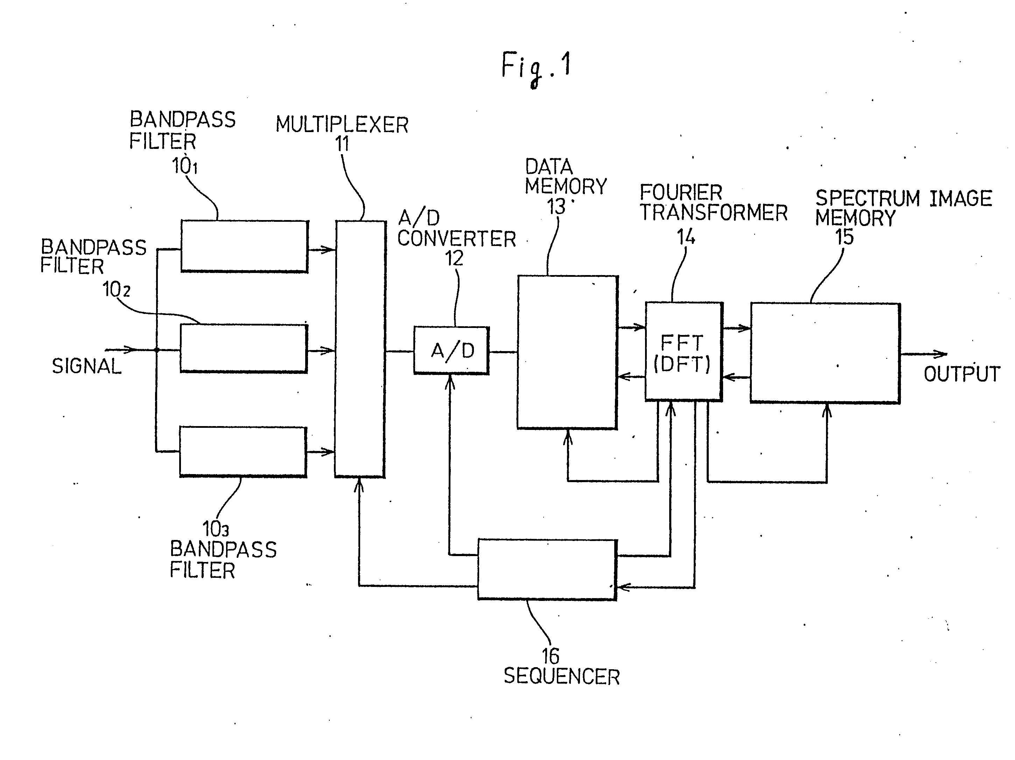

Designated in FIG. 1 at $10_1$, $10_2$, $10_3$ are

bandpass filters, 11 a multiplexer, 12 an analog-to-digital converter (hereinafter referred to as an "A/D converter"), 13 a data memory, 14 a Fourier transformer (FFT or DFT), 15 a spectrum image memory, and 16 a sequencer.

The bandpass filters $10_1$, $10_2$, $10_3$ have passbands of 12.5 through 100 Hz (low band), 100 through 800 Hz (middle band), and 800 Hz to 6.4 KHz (high band), respectively. A signal to be analyzed is applied to these bandpass filters. Output signals from the bandpass filters are selected, one at a time, by the multiplexer 11, and converted by the A/D converter 12 to digital data which is then stored in the data memory 13.

The frequency slot width and the time slot width for the output signal from the bandpass filter $10_1$ are selected to be 6.25 Hz and 160 msec., respectively, in order to gain low-frequency signals by placing more importance on the frequency resolution than on the time resolution. The frequency slot width and the time slot width for the output signal from the bandpass filter $10_2$ are selected to be 50 Hz and 20 msec., respectively, in order to gain middle-frequency signals with moderate frequency and time resolutions. The frequency slot width and the time slot width for the output signal from the bandpass filter $10_3$ are selected to be 400 Hz and 2.5 msec., respectively, in order to gain high-frequency signals including phenomena that happen highly frequently by placing more importance on the time resolution than on the frequency resolution.

The multiplexer 11 samples an equal number of data items during the period of each time slot from the signals in the respective time slots. The number of such data items is determined by the number of inputs and outputs of the Fourier transformer 14, the number of data items being 32 for example. The sampling rates of the multiplexer 11 for the output signals from the bandpass filters $10_1$, $10_2$, $10_3$ are determined as 200 Hz, 1.6 kHz, and 12.8 kHz, respectively, so as to sample 32 data items from each of the output signals of the bandpass filters $10_1$, $10_2$, $10_3$ during the respective time slots 160 msec., 50 msec., and 2.5 msec.

The above relationship is shown in the table 1.

Table 1

|  | Frequency band | Frequency slot width | Time slot width | Sampling rate |
|---|---|---|---|---|
| Low frequencies | 12.5 - 100 Hz | 6.25 Hz. | 160 msec | 200 Hz |
| Middle frequencies | 100 - 800 Hz | 50 Hz | 20 msec | 1.6 kHz |
| High frequencies | 800 Hz - 6.4 kHz | 400 Hz | 2.5 msec | 12.8 kHz |

The timing of the signal sampling by the multiplexer 11 and the A/D conversion by the A/D converter 12 is controlled by the sequencer 16 in order to achieve the sampling rates as shown in the table 1.

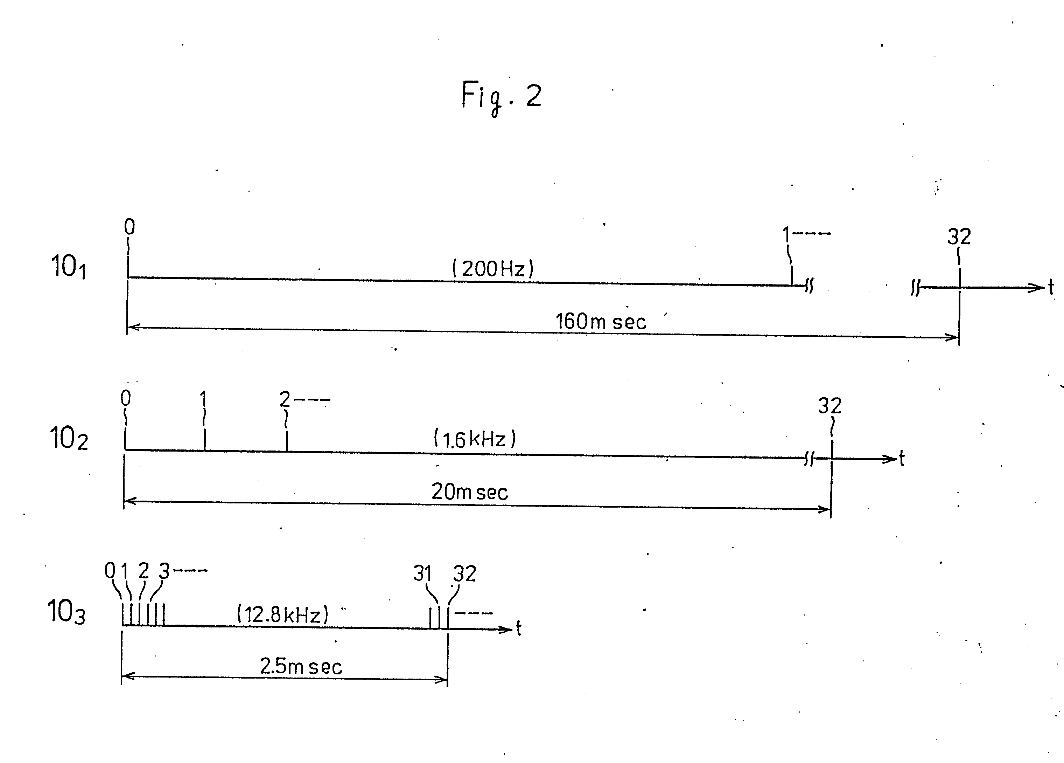

One example of the timing of the data sampling and the A/D conversion for each of the bandpass filters $10_1$, $10_2$, $10_3$ is illustrated in FIG. 2.

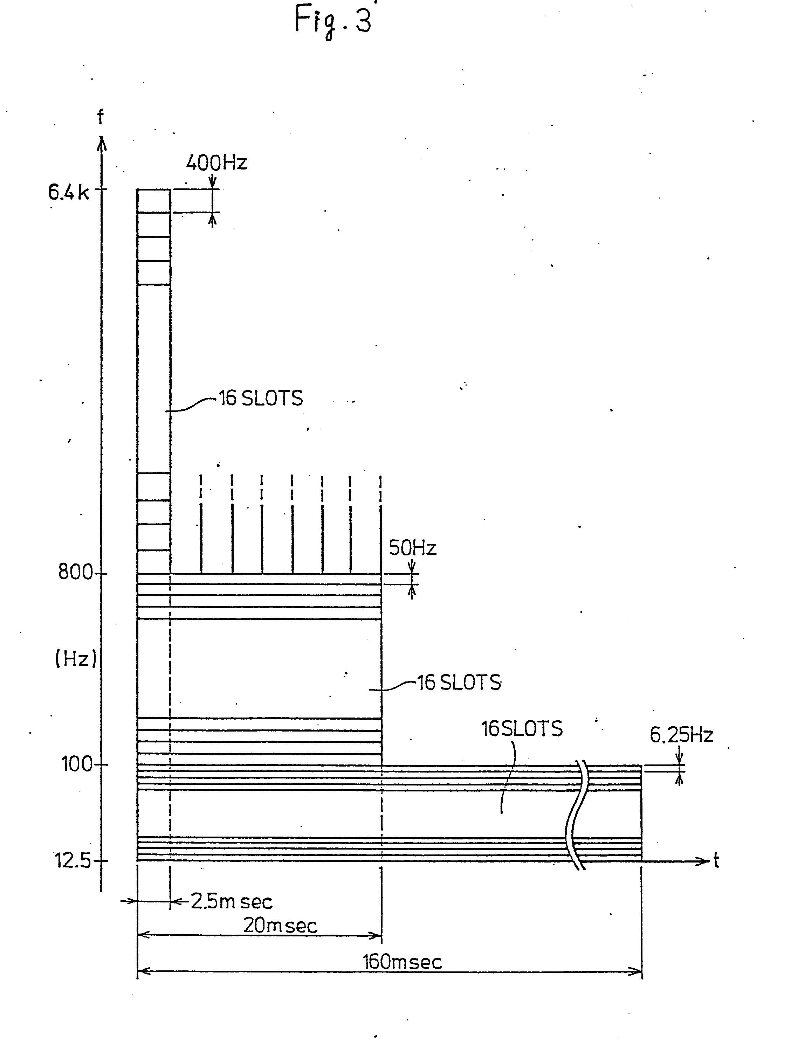

The data items which are sampled by the multiplexer 11 and converted by the A/D converter 12 to digital signals are stored in the data memory 13 for the respective bandpass filters $10_1$, $10_2$, $10_3$. Each time 32 data items from a bandbass filter are stored in the data memory 13, the Fourier transformer 14 effects a Fourier transform and writes a spectrum image formed threby into the memory 15. It is easy to perform the Fourier transform within 2 msec. by using the FFT algorism. A bit map as shown in FIG. 3 is formed in the spectrum image memory 15. The bit map has a horizontal axis representing time and a vertical axis representing frequencies, and contains frequency and time slot groups in the respective frequency bands. In this bit map, the frequency and time slot groups for high frequencies repeatedly appear in each 2.5 msec. in the direction of the time axis, those for middle frequencies repeatedly appear in each 20 msec. in the direction of the time axis, and those for low frequencies repeatedly appear in each 160 msec. in the direction of the time axis.

The analyzed results for high frequencies are written in the bit map in each 2.5 msec., those for middle frequencies are written in the bit map in each 20 msec., and those for low frequencies are written in the bit map in each 160 msec. By reading out the spectrum image stored in the bit map for display or recording, the high frequency components are displayed or recorded at the time resolution of 2.5 msec. Such display or recording is practically sufficient for analyzing the heart function and the blood stream condition. The visual line speed in a human body from which a doppler shift in the high frequency range derives is in the range of from 1.4 m/sec. to 17.5 cm/sec.

assuming that the carrier frequency (ultrasonic frequency

in this case) is 3.5 MHz, and is enough for the observation of normal human artery blood streams. Although the frequency resolution of 400 Hz is coarse, it is in an acceptable range since the frequencies in question are high and it is practically sufficient to be capable of distinguishing between a unidirectional flow and a turbulence such as a vortex for a high-speed blood stream. The frequency and time slot widths for the middle frequency band are suitable for analyzing slower vein blood and lymph streams. The time resolution of 20 msec. is sufficient for such a range of flow speeds because phenomena that happen highly frequently are not required to be analyzed. The frequency and time slot widths for the low frequency band are suitable for analyzing much slower body movements, organ movements, and respiration, for example. The frequency resolution of 6.25 Hz is appropriate for observing such slow movements, and the time resolution of 160 msec. is sufficiently in an acceptable range as the frequency of occurences of phenomena is further lowered. For the high and middle frequency bands, analyzed outputs overlapping those in the respective lower frequency bands are produced as a result of FFT or DFT. However, these overlapping outputs are not utilized.

The frequency bands for a signal to be analyzed are not limited to three freuqency bands, but may be greater or smaller frequency bands.

Although the best mode of carrying out the invention has been described, it should be understood that various changes and modifications may be made therein without departing from the concept of the invention represented by the appended claims.

CLAIMS

1.　　A Doppler signal analyzing apparatus for acquiring a signal to be analyzed for a prescribed time slot and performing a Fourier transform on the acquired signal with Fourier transform means to determine a frequency spectrum of the signal to be analyzed, said Doppler signal analyzing apparatus comprising:

bandpass means ($10_1$, $10_2$, $10_3$) for dividing the signal to be analyzed into a plurality of frequency bands;

signal acquiring means (11) for acquiring signals in the frequency bands which have passed through said bandpass means over time slots that are smaller for higher-frequency signals and larger for lower-frequency signal; and

Fourier transform means (14) for carrying out a Fourier transform on each of the signals acquired by said signal acquiring means.

2.　　A Doppler signal analyzing apparatus according to claim 1, wherein said bandpass means comprises a plurality of bandpass filters to which said signal to be analyzed is applicable.

3.　　A Doppler signal analyzing apparatus according to claim 1, wherein said signal acquiring means includes a multiplexer for selecting, one at a time, the signals in the frequency bands which have passed through said bandpass means.

4.　　A Doppler signal analyzing apparatus according to claim 3, wherein said multiplexer samples a predetermined number of data items during the time slots that are smaller for higher-frequency signals and larger for lower-frequency signal.

5.　　　　A Doppler signal analyzing apparatus according to claim 4, further including an analog-to-digital converter (12) for converting output signals from said multiplexer successively to digital signals, and a data memory (13) for storing the output signals from the analog-to-digital converter in the respective frequency bands for the signal to be analyzed, said Fourier transform means effecting the Fourier transform on the data items in the respective frequency bands which are stored in said data memory.

6.　　　　A Doppler signal analyzing apparatus according to claim 5, wherein said Fourier transform means comprises an FFT device.

7.　　　　A Doppler signal analyzing apparatus according to claim 5, wherein said Fourier transform means comprises an DFT device.

8.　　　　A Doppler signal analyzing apparatus according to claim 1, further including a spectrum memory (15) for storing an output signal from said Fourer transform means.

Fig.1

# Fig. 2

Fig.3

3/3

0217953

# INTERNATIONAL SEARCH REPORT

International Application No. PCT/JP85/00430

## I. CLASSIFICATION OF SUBJECT MATTER (If several classification symbols apply, indicate all) ³

According to International Patent Classification (IPC) or to both National Classification and IPC

Int. Cl⁴ G01R23/16

## II. FIELDS SEARCHED

### Minimum Documentation Searched ⁴

| Classification System | Classification Symbols |
|---|---|
| IPC | G01R23/16, A61B8/00-8/14 |

### Documentation Searched other than Minimum Documentation to the Extent that such Documents are Included in the Fields Searched ⁶

| | |
|---|---|
| Jitsuyo Shinan Koho | 1926 – 1984 |
| Kokai Jitsuyo Shinan Koho | 1971 – 1984 |

## III. DOCUMENTS CONSIDERED TO BE RELEVANT ¹⁴

| Category* | Citation of Document, ¹⁶ with indication, where appropriate, of the relevant passages ¹⁷ | Relevant to Claim No. ¹⁸ |
|---|---|---|
| Y | JP, A, 59-116057 (Victor Co. of Japan, Ltd.) 4 July 1984 (04. 07. 84) & EP, A2, 113275 | 1-8 |
| Y | JP, A, 58-118741 (Toshiba Corp.) 14 July 1983 (14. 07. 83) (Family: none) | 1-8 |
| Y | JP, A, 48-35866 (Hitachi, Ltd.) 26 May 1973 (26. 05. 73), Column 3, lines 14 to 19 & US, A, 3824384 | 7 |

* Special categories of cited documents: ¹⁵

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search ² | Date of Mailing of this International Search Report ² |
|---|---|
| October 9, 1985 (09. 10. 85) | October 21, 1985 (21. 10. 85) |

| International Searching Authority ¹ | Signature of Authorized Officer ²⁰ |
|---|---|
| Japanese Patent Office | |

Form PCT/ISA/210 (second sheet) (October 1981)